(19) **Europäisches Patentamt**

**European Patent Office**

**Office européen des brevets**

(11) **EP 1 705 761 A1**

(12) **EUROPEAN PATENT APPLICATION**
published in accordance with Art. 158(3) EPC

(43) Date of publication:
**27.09.2006 Bulletin 2006/39**

(51) Int Cl.:
*H01S 5/042* (2006.01)    *H04B 10/04* (2006.01)

(21) Application number: **04821107.2**

(22) Date of filing: **06.12.2004**

(86) International application number:
**PCT/JP2004/018129**

(87) International publication number:
**WO 2005/069456 (28.07.2005 Gazette 2005/30)**

(84) Designated Contracting States:
**DE FR GB**

(30) Priority: **15.01.2004 JP 2004007786**

(71) Applicant: **MATSUSHITA ELECTRIC INDUSTRIAL CO., LTD.**
**Kadoma-shi, Osaka 571-8501 (JP)**

(72) Inventors:
• **TOHGOH, Hitomaro,**
  **Matsushita Elec. Ind. Co., Ltd.**
  **Chuo-ku, Osaka 540-6319 (JP)**

• **ODA, Katsuya,**
  **Matsushita Elec. Ind. Co., Ltd.**
  **Osaka 540-6319 (JP)**
• **SATO, Yoshiyasu,**
  **Matsushita Elec. Ind. Co., Ltd.**
  **Chuo-ku, Osaka 540-6319 (JP)**
• **ASANO, Hiroaki,**
  **Matsushita Elec. Ind. Co., Ltd.**
  **Chuo-ku, Osaka 540-6319 (JP)**

(74) Representative: **Grünecker, Kinkeldey,**
**Stockmair & Schwanhäusser**
**Anwaltssozietät**
**Maximilianstrasse 58**
**80538 München (DE)**

(54) **OPTICAL TRANSMITTER**

(57)    An object of the present invention is to provide an optical transmitter that can suppress degradation of distortion characteristic and RIN characteristic caused by relaxation oscillation at high temperature by controlling average driving current of a light emitting element so that the average optical output power of the light emitting element is increased as the temperature increases like a case where the environmental temperature around the light emitting element increases.

*FIG. 1*

EP 1 705 761 A1

## Description

Technical Field

The present invention relates to an optical transmitter in an optical transmission system for distributing video pictures, transmitting mobile wireless signals, etc. by using an optical transmission technique.

Background Art

Transmission of multi-channel video signals, long-distance transmission between a base station and an antenna in a wireless transmission system such as mobile communication or the like, etc. are carried out by using an optical fiber transmission technique in which frequency-multiplexed high frequency signals are superposed on light intensity of a light emitting element (such as laser).

In such an optical transmission system, "distortion characteristic" and "noise characteristic" are known as an index for indicating transmission quality of analog signals such as the frequency-multiplexed signals as described above.

In this optical transmission, the distortion characteristic and the characteristic of "signal to noise ratio" (Relative Intensity Noise, this is referred to as "RIN") of the laser are predominant factors in the distortion characteristic and the noise characteristic. Furthermore, it is known that the "distortion characteristic" and the "RIN characteristic" in the layer have correlation with the "average driving current" of the laser and the amplitude of a high frequency signal (this will be referred to as "high frequency signal amplitude").

From such a situation, the setting of the average driving current of the laser and the setting of the amplitude of the high frequency signal to be superposed on the average driving current are required to be carried out so that the distortion characteristic and the noise characteristic are not degraded.

For example, it is known that when "modulation degree" (=the ratio of the high frequency signal amplitude to the average driving current of laser) is increased, the carrier to noise ratio (Carrier to Noise Ratio, this is referred to as "CNR") is enhanced, however, the "distortion characteristic" of the laser is degraded. Accordingly, it is required to set the modulation degree to the optimal value so that degradation of the distortion characteristic and the noise characteristic of the laser can be suppressed at the maximum.

Furthermore, with respect to the laser, when the temperature is increased, the "slope efficiency" (=the variation of optical power to the driving current of the laser) is reduced. Therefore, it is generally carried out that a monitoring PD (Photo Diode) or the like is provided, monitor PD current output from the monitoring PD is detected, and the "monitoring PD current" is controlled to be fixed by using a control circuit, whereby the optical power is kept fixed ("APC control (automatic power control)"; Automatic Power Control). At the same time, in this laser, when the slope efficiency is lowered, the "high frequency signal amplitude" is lowered and also the "modulation degree" is also reduced. Therefore, it is required to increase the intensity of a modulation signal input to the laser (this is referred to as "modulation signal intensity") (modulation degree control).

The above-described method is a laser modulation method for analog signals, however, the same is applied to a modulation method for digital signals. As a method of modulating digital signals is known a modulation method using the combination of such APC control that the optical power is fixed and such digital signal amplitude control that the optical quenching ratio (= the ratio of the maximum and minimum values of transmitted light intensity when the intensity of the transmitted light is varied by a modulator)is not degraded.

Fig. 8 shows a modulation method of an optical transmitter disclosed in Patent Document 1.
This optical transmitter is equipped with not only a laser (LD) 101 and a modulation circuit 102, but also an APC (automatic power control) circuit 104 for keeping the current of a monitoring light receiving element (for example, photodiode or the like, and this is referred to as "monitor PD") 103 to a fixed value, whereby the driving current of the laser (LD) 101 is controlled. Furthermore, in order to suppress the degradation of the "modulation degree" or the "optical quenching ratio" due to temperature variation, a temperature sensor 105, a temperature control circuit 106 and a cooling element 107 are provided.

In the optical transmitter as described above, when the temperature is increased, there is a tendency that the cooling power of the cooling element 107 is lowered and the temperature of the laser 101 is increased. Therefore, there is known a technique of disposing detecting the temperature variation around the laser 101 by the temperature sensor 105 disposed in the neighborhood of the laser 101 and feeding back the detection value through the temperature control circuit 106 to the modulation circuit 102, whereby correction is carried out so that degradation of "modulation degree" or "optical quenching ratio" which is caused by the temperature increase of the laser 101 does not occur.

As described above, it is a general countermeasure to the temperature variation in the conventional laser modulation system to using a temperature control circuit having a cooling element such as a Peltier element or the like or using optical power and modulation degree control which considers the effect of the temperature variation.

However, the method using the temperature control using the temperature control circuit has a problem that an expensive part such as a Peltier element or the like is needed and also the power consumption of the device is increased. Furthermore, the conventional method relating to the optical power and modulation degree considering the temperature variation merely aims to fix the optical power (APC control) and fix the optical modulation degree (the control of modulation signal intensity), and pays no attention to the temperature variation of the distortion characteristic and the noise characteristic of the laser, and thus degradation of the characteristics under high temperature cannot be perfectly removed.

Furthermore, with respect to analog transmission such as video signal transmission or the communication between a mobile and a base station, by increasing the optical signal power, long-distance transmission can be performed and also the number of optical branches can be increased. Therefore, it is also required to increase the optical power as much as possible by increasing the average driving current.

However, when the optical power is excessively increased in the analog transmission, the lifetime of the laser is shortened and thus there is a situation that the optical power cannot be increased more than necessary.

Furthermore, as described in non-patent document 1 and Patent Document 2, it is known that "relaxation oscillation frequency $f_r$ " (characteristic frequency of semiconductor laser) is one of degradation factors of the distortion characteristic and RIN of the laser.

That is, it is theoretically known that the relaxation oscillation frequency $f_r$ has the correlation with the driving current (bias current) $I_b$ of the laser and the threshold current of the laser (the current needed for the laser to start excitation) $I_{th}$ represented by the following equation:

$$f_r \propto [(I_b - I_{th})/I_{th}]^{1/2}$$

Accordingly, according to the equation (1) defining the relaxation oscillation frequency $f_r$, it is mathematically understandable that as the threshold current $I_{th}$ is larger or as the driving current $I_b$ of the laser is smaller, the relaxation oscillation frequency $f_r$ is reduced to a lower value.

It is also known that when the relaxation oscillation frequency $f_r$ is lowered, the carrier (carrier wave) signal frequency approaches to the relaxation oscillation frequency $f_r$, so that the distortion characteristic and the RIN characteristic are degraded. However, the relaxation oscillation frequency $f_r$ also has a characteristic that it is greatly dependent on the temperature. Therefore, the temperature around the laser may exercise an adverse effect on the distortion characteristic and the RIN characteristic, however, the conventional modulation system has no attention to the characteristic degrading factor described above.

The present invention has been implemented in view of the foregoing problem, and has an object to provide an optical transmitter that can suppress degradation of the characteristic of a light emitting element which is caused by relaxation oscillation when the environment temperature around the light emitting element is increased.

Patent Document 1: JP-A-2001-156719

Non-Patent Document 1: "IEEE JOURNAL OF SELECTED AREAS IN COMMUNICATIONS", Vol. 8, No. 7, pp1359-1364, 1990
Patent Document 2: JP-A-2003-224522

Disclosure of the Invention

First, according to the present invention, an optical transmitter equipped with a light emitting element for outputting signal light which is subjected to light intensity modulation is characterized by comprising control unit for increasing average optical power of the light emitting element when the environment temperature in the vicinity of the light emitting element increases. The conventional method relating to the optical power and modulation degree control carried out in consideration of the temperature variation merely aims to fix the optical power (APC control) and fix the optical modulation degree (the control of the modulation signal intensity). Accordingly, when a (semiconductor) laser is used as a light emitting element, the characteristic degradation under high temperature cannot be perfectly removed because no attention is paid to the temperature variation of "distortion characteristic" and "noise characteristic" of the laser. However, according to the present invention, the characteristic degradation under high temperature can be removed. That is, degradation of "distortion characteristic" and "RIN characteristic" which are caused by "relaxation oscillation" under high temperature can be suppressed.

Secondly, the optical transmitter of the present invention is characterized in that the control unit controls the average driving current of the light emitting element. Accordingly, it is unnecessary to provide a temperature control circuit having an expensive part such as a Peltier element (cooling element) or the like (however, a temperature sensor and a temperature detecting circuit are needed), and thus the power consumption of the optical transmitter can be reduced.

Thirdly, the optical transmitter of the present invention is characterized in that the control unit controls the average driving current in accordance with the environmental temperature around the light emitting element. Accordingly, the average driving current is controlled to be larger as compared with the APC control so that the laser average output light (power) is more increased as the temperature increases, thereby suppressing the degradation of the distortion characteristic and the RIN characteristic which are caused by reduction of the relaxation oscillation frequency.

Fourthly, the optical transmitter of the present invention is characterized in that the control unit controls the average driving current on the basis of only data corresponding to the environmental temperature around the light emitting element. Accordingly, no monitoring PD is needed.

Brief Description of the Drawings

[Fig. 1] is a block diagram showing the construction of an optical transmitter according to a first embodiment of the present invention.

[Fig. 2] is a graph showing the difference in temperature dependence of optical power between a laser according to the first embodiment of the present invention and a conventional laser.

[Fig. 3] is a graph showing the difference in temperature dependence of relaxation oscillation frequency between the laser according to the first embodiment of the present invention and the conventional laser.

[Fig. 4] is a graph showing the temperature dependence of a slope efficiency of the laser according to the first embodiment of the present invention.

[Fig. 5] is a graph showing the temperature dependence of a threshold current of the laser according to the first embodiment of the present invention.

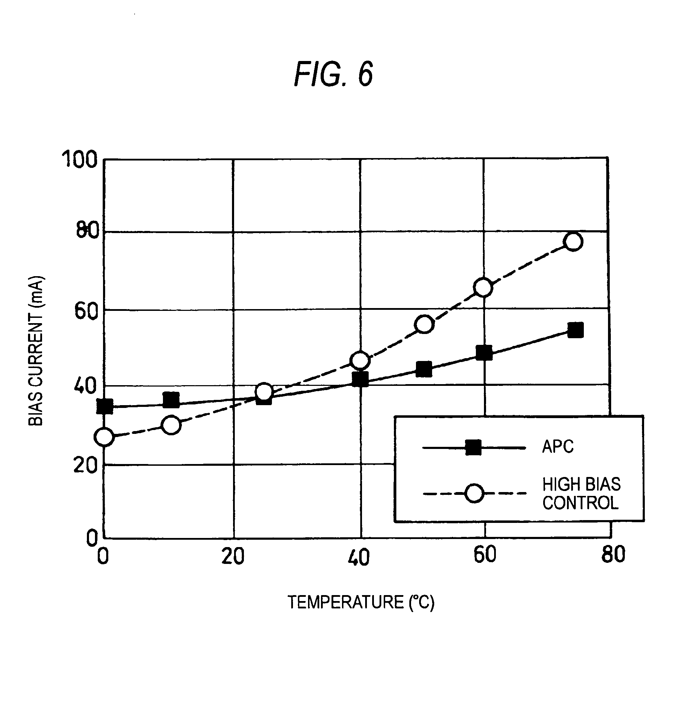

[Fig. 6] is a graph showing the difference of the temperature dependence of driving current between the laser according to the first embodiment of the present invention and the conventional laser.

[Fig. 7] is a block diagram showing the construction of an average driving current control circuit according to a third embodiment of the present invention.

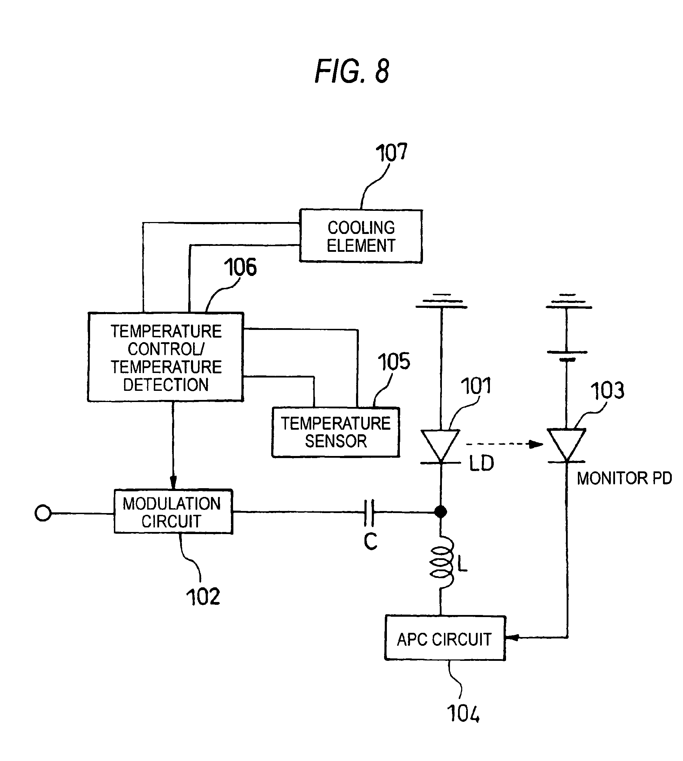

[Fig. 8] is a block diagram showing the construction of a conventional optical transmitter.

[Fig. 9] is a graph showing the temperature dependence of the driving current according to a conventional laser modulating method.

[Fig. 10] is a graph showing the temperature dependence of relaxation oscillation frequency according to the conventional laser modulating method.

Description of Reference Numerals

1    data input terminal

2    modulation circuit

3    light emitting element (semiconductor laser;LD)

4    monitor PD

5    temperature sensor

6    temperature detecting circuit

7    average driving current control circuit (control unit)

71    constant current circuit

72    variable resistor

73    variable resistor (voltage control type)

Best Modes for carrying out the Invention

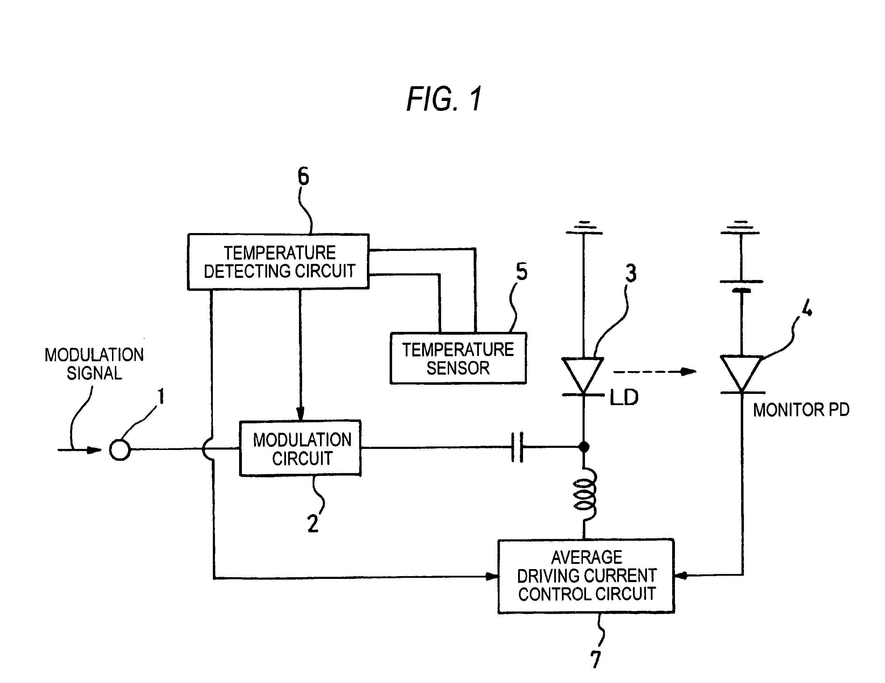

Embodiments of the present invention will be described in detail with reference to the accompanying drawings.
[First Embodiment]
Fig. 1 shows an optical transmitter according to an embodiment of the present invention. The optical transmitter is equipped with a data input terminal 1, a modulation circuit 2, a semiconductor laser (LD) 3 serving as a light emitting element, a monitor PD 4, a temperature sensor 5, a temperature detecting circuit 6 and an average driving current control circuit 7.

An end face light emission type is used as the semiconductor laser 3, and specifically a Fabry- Perot type laser (FP-LD) is used. However, a distributed feedback type laser (DFB) for emitting coherent light of stable single mode or the like may be used.

The monitor PD 4 monitors the intensity of emitted light of the semiconductor laser 3. When receiving output backlight of the end face emission type semiconductor laser 3, the monitor PD 4 carries out photoelectrical conversion to generate photocurrent (monitor PD current), and also outputs the monitor PD current to the average driving current control circuit 7. Therefore, the output of the monitor PD4 is connected to the input of the average driving current control circuit 7.

When detecting the environmental temperature (ambient temperature) of the semiconductor laser 3, the temperature sensor 5 outputs the voltage corresponding to the temperature thus detected, and the output thereof is connected to the input of the average driving current control circuit.

The temperature detecting circuit 6 outputs a predetermined detection signal to the modulation circuit 2 and the average driving current control circuit 7 in response to a voltage signal from the temperature sensor 5. The input of the temperature detecting circuit 6 is connected to the output of the temperature sensor 5, and the output thereof is connected to the respective inputs of the modulation circuit 2 and average driving current control circuit 7.

The average driving current control circuit 7 controls the average driving current of the semiconductor laser in accordance with the detection signal of the temperature detecting circuit 6. In this case, current control is carried out so that as the ambient temperature of the semiconductor laser (LD) 3 increases, the monitor PD current output from the monitor PD4 is increased, and thus the average driving current of the semiconductor laser 3 is increased. In accordance with the monitor PD current of the monitor PD4 and the detection signal of the temperature detecting circuit 6, a predetermined average driving current in consideration of the environmental temperature of the periphery of the semiconductor laser 3 is input as bias current I to the semiconductor laser (LD) 3.

Here, the definition, etc. of main terms used in the present invention will be described hereunder for confirmation.

The driving current ($I_b$) is defined as current (injection current) exceeding a threshold level needed to drive the semiconductor laser 3. When modulation signal current is superposed on laser driving current, an amplitude-modulated optical signal is achieved. A method of superposing the modulation signal on the laser driving current to achieve signal light as described above will be referred to as a direct modulation method.

The driving current output from the average driving current control circuit is referred to as "average driving current" by adding a word "average" to the head of "driving current". In this invention, attention is paid to variation of environmental temperature which is a relatively moderate time variation (variation of about several-second order at most, and the driving signal is varied while imitating the temperature variation concerned. Accordingly, the average value of the driving current for about several seconds will be referred to as "average driving current". Furthermore, the same is applied to "average optical output (power)" described later.

Next, the operation of this embodiment will be described.

A data signal which is input to a data input terminal 1 and is to be transmitted, that is, a modulation signal is input to the modulation circuit 2. In the modulation circuit 2, modulation current corresponding to the data signal is generated, and the modulation current thus generated is input to the semiconductor laser 3. The semiconductor laser 3 is also supplied with driving current from the average driving current control circuit 7, whereby the semiconductor laser 3 is excited and emits coherent light having a predetermined wavelength which is subjected to light intensity modulation by the direct modulation system. At this time, the monitor PD current of the monitor PD 4 for monitoring the emitted light intensity of the semiconductor laser 3 and the output voltage of the temperature sensor 5 for measuring the environmental temperature of the periphery of the semiconductor laser (LD) 3 are input to the average driving current control circuit 7.

In the average driving current control circuit 7, the driving current is controlled so that the monitor PD current is increased as the environmental temperature of the periphery of the semiconductor laser 3 increases, and the driving current thus controlled is input as average driving (bias) current to the semiconductor laser 3, whereby the average driving (bias) current is controlled in accordance with the variation of the environmental temperature of the semiconductor laser 3.

In order to compensate for the variation of the slope efficiency (= a variation of the optical output (power) to the driving current of the laser) of the semiconductor laser 3 to the temperature variation described above, in the modulation circuit 2 the modulation degree of the semiconductor laser 3 is also controlled with the detection signal from the temperature detecting circuit 6 which is based on the output voltage of the temperature sensor 5.

Accordingly, for example when the environmental temperature of the semiconductor laser 3 increases, the average driving current control circuit 7 increases the average driving (bias) current so that the monitor PD current of the monitor PD4 is increased, whereby the average optical output (power) is increased. Conversely, when the environmental temperature of the semiconductor laser 3 decreases, the average driving current control circuit 7 reduces the average driving (bias) current so that the monitor PD current of the monitor PD4 is reduced, whereby the average optical output is reduced. The output control is carried out so that the optical output of the semiconductor laser 3 is increased in connection with the increase of the environmental temperature of the semiconductor laser 3 as described above.

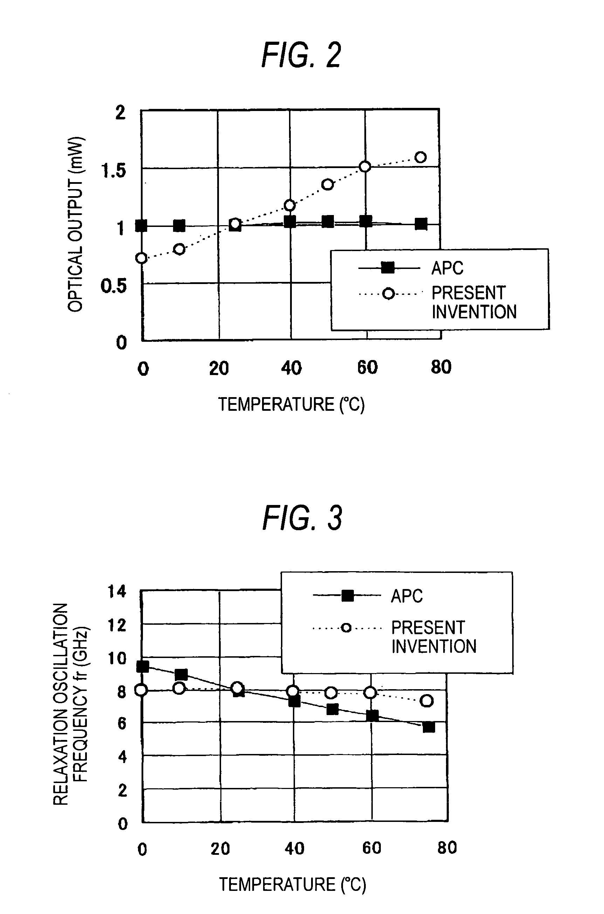

Next, with respect to a method of controlling the driving current of the semiconductor laser 3 and a method of controlling the modulation degree, the principles thereof will be described hereunder in detail. Figs. 2 and 3 show examples of the temperature variation of "average optical output (power)" and "relaxation oscillation frequency $f_r$" in a case where the conventional APC control for fixing the average optical output (power) is carried out and in a case where the temperature control of the first embodiment of the present invention is carried out.

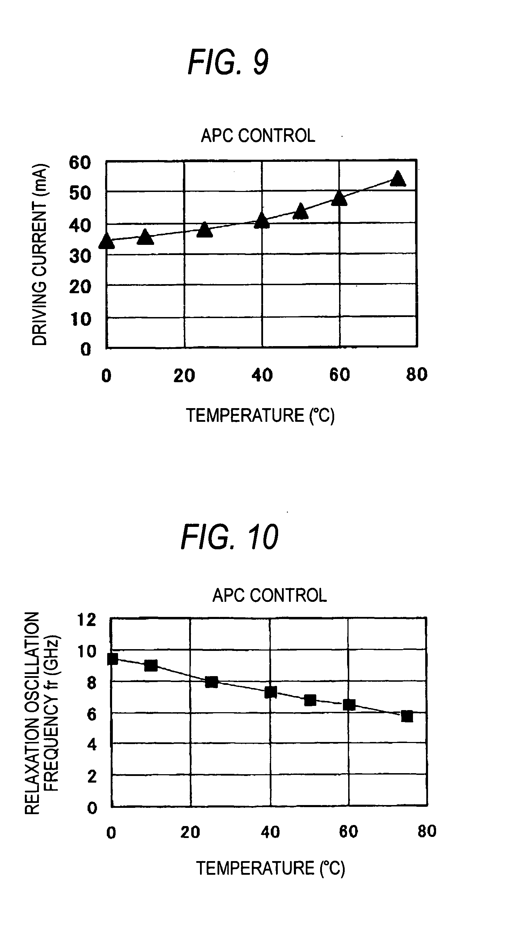

In the conventional APC control, the driving current is increased under the state that the environmental temperature in the vicinity of the semiconductor laser 3 is high as shown in Fig. 9. However, according to the results of various experiments and analysis carried out by the inventor of this invention, it has been found that even when the "relaxation oscillation frequency $f_r$" is reduced as shown in Fig. 10 at high temperature even when the APC control is carried out, and this serves as one of predominant factors inducing degradation of "distortion characteristic" and "RIN characteristic" at high temperature.

On the other hand, according to the temperature control of the present invention, the average optical output (power) is increased as the environmental temperature around the semiconductor laser 3 increases as shown in Fig. 2 by increasing the driving current more than that in the conventional APC control. With this construction, it has been confirmed that the reduction of "relaxation oscillation frequency $f_r$" at high temperature can be excellently controlled, that is, the "relaxation oscillation frequency $f_r$" can be kept substantially constant from a low temperature (for example, 0°C) to a high temperature (for example, 80°C) as shown in Fig. 3.

As described above, the inventor has the following knowledge. That is, if the average optical output (power) of the semiconductor laser 3 is not controlled so as to be fixed irrespective of the peripheral temperature of the semiconductor laser 3, but the average driving current of the semiconductor laser 3 is controlled so that "the average optical output (power) is increased as the environmental temperature of the semiconductor laser 3 is increased (see Fig. 2)", the degradation of "distortion characteristic" and "RIN characteristic" which are caused by "relaxation oscillation frequency $f_r$" when the ambient temperature of the semiconductor laser 3 is high can be excellently suppressed. The reason for this will be described hereunder in detail.

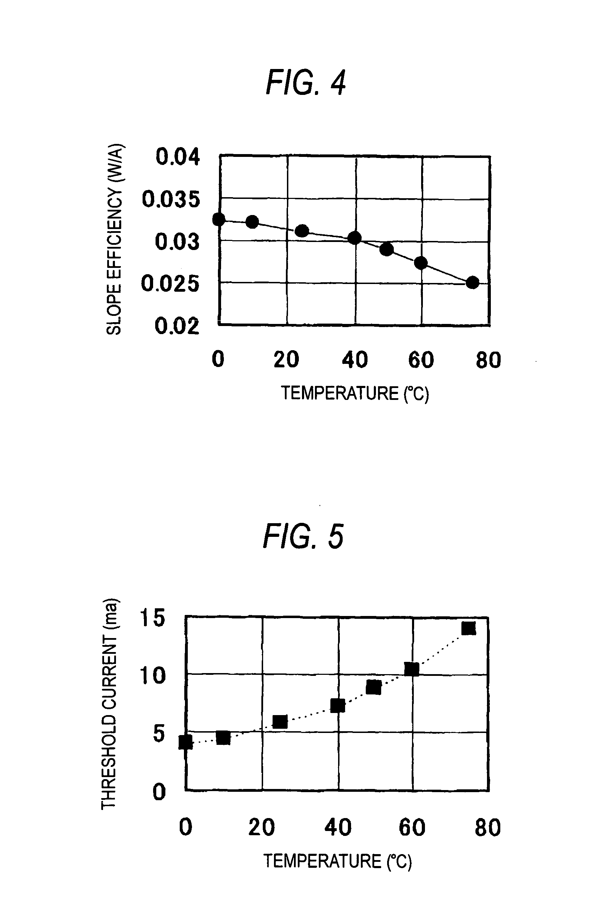

First, Figs. 4 and 5 show examples of estimation results on the temperature dependence of "slope efficiency" (= the variation rate of the optical output power to the driving current of the laser) and the threshold current (the current needed for the laser to excite) of a Fabry-Perot type laser (FP-LD).

As shown in Fig. 4, the slope efficiency (W/A) of the semiconductor laser 3 is reduced as the ambient temperature of the semiconductor laser 3 increases, and thus the current control is carried out under the conventional APC control so that the average driving current is increased under high temperature.

That is, according to the conventional modulation system, as described in the column of "Background Art", the APC control is carried out so that the average optical output (power) is fixed. Fig. 9 shows a graph showing an aspect of the variation of the average driving current with respect to the temperature, which was achieved when the APC control was actually carried out.

Furthermore, Fig. 10 shows the variation of the "relaxation oscillation frequency $f_r$" of the semiconductor laser 3 when the current control under the APC control was carried out.

It is apparent that under the conventional APC control, the "relaxation oscillation frequency fr" is gradually reduced as the ambient temperature of the semiconductor laser 3 increases as shown in Fig. 10, and "distortion characteristic" and "RIN characteristic" is degraded at high temperature.

With respect to the actual laser, according to the conventional APC control, the threshold current $I_{th}$ is more greatly increased than the increase of the driving current $I_b$ at high temperature, and thus the term of the threshold current $I_{th}$ corresponding to the dominator and the numerator of the equation (1) has a greater effect. Therefore, actually, the "relaxation oscillation frequency $f_r$" at high temperature is reduced, which makes the "relaxation oscillation frequency $f_r$" become a graph (function) plotting a monotone-decreasing curve as shown in Fig. 10.

As described above, the conventional APC control system is the control of increasing the average driving current $I_b$ at high temperature, however, it has been found through inventor's experiments that it is insufficient to suppress the degradation of "relaxation oscillation frequency $f_r$" and it is necessary to further increase the average driving current $I_b$.

That is, it has been found that the suppression of the degradation of "distortion characteristic" and "RIN characteristic" due to "relaxation oscillation" can be performed by driving current still larger than the average driving current value based on the APC control at high temperature.

Particularly when the frequency of the transmission signal is high, it approaches to the relaxation oscillation frequency and thus it is liable to be influenced by the relaxation oscillation frequency, so that the characteristic improving effect of this embodiment is further enhanced.

[Second Embodiment]

Next, a second embodiment according to the present invention will be described.

A feed-forward method is known as one method of controlling the driving current so that the optical power is increased in connection with the temperature increase. This method will be described hereunder. In this embodiment, the same circuit construction as the first embodiment may be used, however, the monitor PD is unnecessary.

i) First, the temperature dependence of the semiconductor laser 3 on the threshold current $I_{th}$ ($I_{th} = I_{th}(T)$, T: temperature) is measured, and the temperature dependence function $I_b(T)$ of the driving current $I_b$ is determined so that the "relaxation oscillation frequency fr" of the equation (1) described above does not decrease.

ii) secondly, there may be provided a driving current control circuit for varying the driving current $I_b$ on the basis of the function of the output voltage of the temperature sensor so as to satisfy the driving current $I_b = I_b(T)$, and outputting the driving current $I_b$ to the semiconductor laser.

With this construction, the average driving current is uniquely determined with respect to the temperature T. Therefore, it is unnecessary to input the monitor PD current to the feed-forward type average driving current control circuit, and only an output signal of the temperature sensor 5 may be input thereto. That is, in this embodiment, the optical transmitter can be implemented by the construction excluding the monitor PD in the first embodiment as described above.

When some dispersion occurs in samples of the threshold current $I_{th}$ and the temperature dependence of the semiconductor laser 3 being used according to the feed-forward system, it is necessary to estimate the temperature dependence every semiconductor laser 3, and thus some degree of time is needed for the process of manufacturing the optical transmitter having the semiconductor laser.

[Third Embodiment]

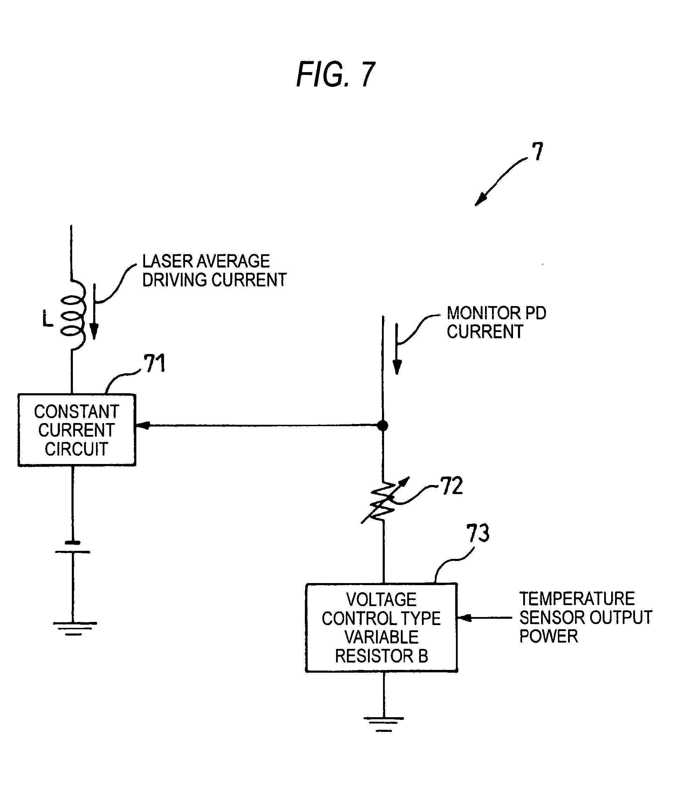

Next, an optical transmitter according to a third embodiment of the present invention which uses the other driving current control method will be described with reference to Fig. 7. In this embodiment, the same parts as the first embodiment will be represented by the same reference numerals, and the duplicative description thereof is avoided.

The difference of the optical transmitter of this embodiment from the first embodiment resides in the average driving current control circuit 7 shown in Fig. 7. The average driving current control circuit 7 will be mainly described hereunder.

In the average driving current control circuit 7 of this embodiment, a variable resistor 72 is inserted in parallel between the voltage input terminal of a constant current circuit 71 for controlling current and the output terminal of monitor PD, and also a voltage control type variable resistor 72 is additionally inserted to be connected to the variable resistor 72 in series. Specifically, the average driving current control circuit 7 is designed so that the control voltage input terminal of the constant current circuit 71 for supplying laser driving current is connected to the input of the monitor PD, and the variable resistors 72 and 73 are provided between the control voltage input terminal and the ground.

The output of the temperature detecting circuit 6 is connected to the series connected variable resistor 73, and the resistance value is varied in accordance with the detection signal. The variation of the resistance value of the variable resistor varies the control voltage based on the monitor PD current, and the driving current is controlled.

The optical output power is determined by the sum of the resistance values of the variable resistors 73 and 72. At normal temperature, desired optical power can be set by adjusting the variable resistor 72. On the other hand, the resistance value of the variable resistor 73 is controlled by the output voltage of the temperature sensor 5, and it is controlled so that the resistance value is increased under the state that the temperature of the surrounding of the semiconductor laser is high, and the laser driving current is increased.

Accordingly, the laser average driving current is larger than the laser average driving current under the conventional APC control at high temperature, and the control of increasing the average optical output (power) at high temperature can be easily performed. The increasing degree of the average optical output at high temperature is determined by the resistance value of the variable resistor 73 and the variation rate to the output voltage of the temperature sensor 5.

As compared with the feed-forward system of the second embodiment, according to the control method of the third embodiment, the average optical power control of a higher output can be more easily performed at high temperature without measuring the temperature dependence of the threshold current $I_{th}$ of the laser in advance, and also the feedback control of the average optical power is carried out, so that the laser optical output can be stabilized.

It has been found by the inventor that the degradation of "distortion characteristic" and "RIN characteristic" due to "relaxation oscillation" is suppressed as the increasing degree of the optical power at high temperature is larger. However, if the increasing degree of the optical power is excessively larger, the optical power at high temperature is increased, so that the lifetime of the laser may be lowered. However, if "relaxation oscillation frequency" is not lowered, "distortion characteristic" and "RIN characteristic" would not be degraded. Therefore, as "relaxation oscillation frequency" increases, large optical power is unnecessary. Therefore, in this embodiment, this can be easily implemented by setting the resistance values of the variable resistors 72 and 73 to the optimal value.

In the driving current control system of the present invention, temperature variation occurs in the average optical output (power) as shown in Fig. 2, and a countermeasure to the temperature variation will be described hereunder.

In the transmission of analog signals, unlike the digital transmission, if the modulation signal intensity of the laser is fixed, the reception signal level is hardly varied even when the average driving current of the laser (= DC component of the signal) is varied. Accordingly, the signal level variation and the variation of the average driving current are irrelevant to each other, and the control for suppressing the signal level variation may be carried out independently of the driving current control described above.

This can be implemented by providing the modulating circuit 2 with a control circuit for measuring the dependence of the slope efficiency on the temperature variation in advance and varying the modulation signal intensity in accordance with the temperature. Furthermore, in the optical transmission system, it is general that in consideration of dispersion of the transmission loss a reception dynamic range is secured at the optical receiver so that the reception level may be varied, and some degree of amplitude variation of the modulation signal is allowed.

As described above, the temperature variation of the average optical power based on the driving current control system of the present invention does not affect the transmission characteristic of analog signals, and the signal level adjustment can be implemented independently of the modulation degree control.

Furthermore, in the driving current control of the above embodiment, the average optical power is controlled so that "relaxation oscillation frequency" is not degraded over the range from low temperature to high temperature. Therefore, in the case of the present invention, the effect of "relaxation oscillation frequency" is small at the low temperature, and thus the control of the average optical power may be performed only in a high temperature area above a predetermined temperature.

Still furthermore, the present invention relates to the optical transmitter which is designed to implement the control concerning the average driving current in order to suppress the characteristic degradation of the light emitting element which is caused by the carrier (carrier wave) signal frequency, and no reference is made to the modulation signal.

In the prior art, the temperature sensor is located adjacently to the semiconductor laser in order to accurately measure the temperature of the semiconductor laser. However, in the present invention, the temperature control of the driving current described above is carried out on the operating environmental temperature, and the temperature sensor is designed so as to measure the temperature at a place which is slightly away from the light emitting element (semiconductor laser).

This is because according to the driving current control method of the present invention, when the temperature of the light emitting element (semiconductor laser) is increased by the increase of the driving current at high temperature and this temperature increase is detected by the temperature sensor, positive feedback is applied to the driving current of the light emitting element (semiconductor laser), and the control circuit may be run away.

The present invention has been described in detail by referring to the specific embodiments, however, it is obvious to persons skilled in the art that various modifications and alterations can be applied without departing from the subject matter of the spirit and scope of the present invention.

This application is based on Japanese Patent Application (Japanese Patent Application No. 2004-007786) filed on January 15, 2004, and the content thereof is taken in here as a reference.

Industrial Applicability

According to the present invention, the average driving current of the light emitting element is controlled so as to be increased as the temperature of the average optical output (power) of the light emitting element increases, whereby it is possible to suppress degradation of the distortion characteristic and the RIN characteristic which is caused by the relaxation oscillation at high temperature, and also the present invention is effective used as an optical transmitter in an optical transmission system for carrying out video picture distribution and mobile wireless signal transmission by using the optical transmission technique.

**Claims**

1. An optical transmitter, comprising:

    a light emitting element that outputs signal light subjected to light intensity modulation; and
    a control unit that increases an average optical output of the light emitting element when the environmental temperature in the vicinity of the light emitting element increases.

2. The optical transmitter according to claim 1, wherein the control unit controls average driving current of the light emitting element.

3. The optical transmitter according to claim 2, wherein the control unit controls the average driving current in accordance with the environmental temperature in the vicinity of the light emitting element and the average optical output of the light emitting element.

4. The optical transmitter according to claim 1, wherein the control unit controls the average driving current based on only the data corresponding to the environmental temperature in the vicinity of the light emitting element.

EP 1 705 761 A1

## FIG. 1

MODULATION
SIGNAL

TEMPERATURE
DETECTING CIRCUIT  6

TEMPERATURE
SENSOR  5

LD  3

MONITOR PD  4

MODULATION
CIRCUIT  2

1

AVERAGE
DRIVING CURRENT
CONTROL CIRCUIT  7

## FIG. 2

## FIG. 3

## FIG. 4

## FIG. 5

## FIG. 6

## FIG. 7

7

LASER AVERAGE
DRIVING CURRENT

L

MONITOR PD
CURRENT

71

CONSTANT
CURRENT
CIRCUIT

72

73

VOLTAGE
CONTROL TYPE
VARIABLE
RESISTOR B

TEMPERATURE
SENSOR OUTPUT
POWER

## FIG. 8

## FIG. 9

APC CONTROL

## FIG. 10

APC CONTROL

## INTERNATIONAL SEARCH REPORT

| International application No. |
|---|
| PCT/JP2004/018129 |

| A. CLASSIFICATION OF SUBJECT MATTER |
|---|
| Int.Cl$^7$ H01S5/042, H04B10/04 |

According to International Patent Classification (IPC) or to both national classification and IPC

| B. FIELDS SEARCHED |
|---|
| Minimum documentation searched (classification system followed by classification symbols)<br>Int.Cl$^7$ H01S5/00-5/50, H04B10/00-10/28 |

| Documentation searched other than minimum documentation to the extent that such documents are included in the fields searched |
|---|

| | | | |
|---|---|---|---|
| Jitsuyo Shinan Koho | 1922-1996 | Toroku Jitsuyo Shinan Koho | 1994-2004 |
| Kokai Jitsuyo Shinan Koho | 1971-2004 | Jitsuyo Shinan Toroku Koho | 1996-2004 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | JP 2003-273449 A (Sony Corp.),<br>26 September, 2003 (26.09.03),<br>Full text<br>(Family: none) | 1-4 |
| A | JP 2003-115800 A (Nippon Telegraph And Telephone Corp.),<br>18 April, 2003 (18.04.03),<br>Full text<br>(Family: none) | 1-4 |
| A | JP 09-321375 A (Lucent Technologies Inc.),<br>12 December, 1997 (12.12.97),<br>Full text<br>& US 5844928 A1 & EP 0793316 A1 | 1-4 |

| ☒ Further documents are listed in the continuation of Box C. | ☐ See patent family annex. |
|---|---|

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search<br>24 February, 2005 (24.02.05) | Date of mailing of the international search report<br>15 March, 2005 (15.03.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

International application No.

PCT/JP2004/018129

C (Continuation).   DOCUMENTS CONSIDERED TO BE RELEVANT

| Category* | Citation of document, with indication, where appropriate, of the relevant passages | Relevant to claim No. |
|---|---|---|
| A | JP 09-129970 A  (NEC Corp.),<br>16 May, 1997 (16.05.97),<br>Fig. 7; Par. No. [0033]<br>& EP 0772267 A1 | 1-4 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001156719 A
- JP 2003224522 A

- JP 2004007786 A

**Non-patent literature cited in the description**

- *IEEE JOURNAL OF SELECTED AREAS IN COM-MUNICATIONS,* 1990, vol. 8 (7), 1359-1364